# EUROPÄISCHE PATENTSCHRIFT

(11) **EP 1 586 004 B1**
(45) Veröffentlichungstag und Bekanntmachung des Hinweises auf die Patenterteilung: **26.01.2011**
(21) Anmeldenummer: 03815039.7
(22) Anmeldetag: 16.12.2003
(51) Int. Cl.: G02F 1/1362, H01L 51/40, G06K 19/077

(54) **PLATINE ODER SUBSTRAT FÜR EIN ORGANISCHES ELEKTRONIKGERÄT, SOWIE VERWENDUNG DAZU**
BOARD OR SUBSTRATE FOR AN ORGANIC ELECTRONIC DEVICE AND USE THEREOF
PLATINE OU SUBSTRAT POUR UN APPAREIL ELECTRONIQUE ORGANIQUE ET UTILISATION DE LADITE PLATINE

(30) Priorität: 09.01.2003 DE 10300519
(43) Veröffentlichungstag der Anmeldung: 19.10.2005
(73) Patentinhaber: PolyIC GmbH & Co. KG, 90763 Fürth (DE)
(72) Erfinder: CLEMENS, Wolfgang, 90617 Puschendorf (DE); GERIT, Axel, 90766 Fürth (DE)
(74) Vertreter: Zinsinger, Norbert
(86) Internationale Anmeldenummer: PCT/DE2003/004151
(87) Internationale Veröffentlichungsnummer: WO 2004/063806

(56) Entgegenhaltungen:
- DE-A- 3 338 597
- DE-A- 10 045 192
- DE-A- 10 047 171
- DE-A- 10 120 687
- DE-A- 19 935 527
- US-A- 5 693 956

## Beschreibung

Die Erfindung betrifft eine Platine oder ein Substrat für ein elektronisches Gerät, die kostengünstig herstellbar ist und einfach in den Produktionsprozess für organische Elektronik integrierbar ist.

Bekannt sind elektronische Bauteile, die auf sogenannten Platinen aufgebracht sind. Dabei werden einzelne aktive elektronische Elemente wie Transistoren, integrierte Schaltungen etc. auf die passive Platine gelötet und leitend entweder durch vorstrukturierte Leiterbahnen auf der Platine oder durch Kabelleitungen verbunden. Die einzelnen aktiven elektronischen Bauteile werden dabei alle extra gefertigt und in einem extra Arbeitsschritt auf die Platine montiert (Hybridaufbau). Bisher ist es nur möglich, passive Bauteile wie Widerstände oder Kondensatoren in solche Platinen zu integrieren, alle aktiven Teile werden wie beschrieben hybrid aufgebaut.

Der nächste Stand der Technik, die DE 199 35 527 A1, beschreibt Chipkarten mit Display und ein Verfahren zum Herstellen von Anzeigeelementen mit elektronischer Ansteuerung und Ansteuerleitungen für die Anzeigeelemente. Dabei ist beschrieben, die optischen Anzeigeelemente als auch die elektronischen Ansteuerungsbestandteile, gegebenenfalls auch eine Spannungsquelle, mittels organischen Halbeitermaterialien nebeneinander auf einer Kunststofffolie anzuordnen.

Die DE 33 38 597 A1 offenbart einen mehrschichtigen Datenträger, in welchen ein einen IC-Baustein aufnehmendes Trägerelement eingebaut ist, sowie ein Verfahren zur Herstellung eines solchen Datenträgers.

Bekannt ist in der organischen Elektronik, der sogenannten Polymerelektronik, organische basierte (nicht notwendigerweise nur aus polymeren, sondern allgemeiner gesehen aus leitfähigen, halbleitenden, und isolierenden organischen, also nicht Silizium enthaltenden Materialien) aktive Bauteile wie Transistoren oder passive Bauteile wie Widerstände auf Substraten, vorzugsweise auch flexiblen Substraten, aufzubauen.

Zur Realisierung der sogenannten organischen Elektronik, der Elektronik die nicht auf den traditionellen Halbleitern mit Silizium als Kernelement aufbaut, sondern die organische halbleitende und leitende Materialien umfasst, ist es notwendig, eine möglichst preisgünstige Elektronik zur Verfügung zu stellen.

Aufgabe der vorliegenden Erfindung ist es daher, eine Platine, ein Substrat oder eine Grundplatte (alle drei Begriffe stehen hier für dieselbe Vorrichtung) für ein organisches Gerät zu schaffen, die intelligent ist oder in die passive und/oder aktive elektronische Bauteile integriert sind. Diese Aufgabe wird gelöst durch eine Platine nach Anspruch 1.

Aktive Bauteile sind dabei Transistoren, Dioden, Photozellen, integrierte Schaltungen oder ähnliches. Weiterhin ist in die Platine oder das Substrat vorzugsweise zumindest ein aktives organisches Bauteil neben zumindest einem passiven organischen Bauteil integriert. Passive Bauteile sind dabei Widerstände, Spulen und/oder Kondensatoren.

"Integriert" versteht sich hier als Gegensatz zu dem genannten Hybridaufbau. Die integrierten Bauteile werden demnach nicht extra gefertigt und/oder in einem extra Arbeitsschritt auf das Substrat montiert, sondern das Substrat dient nach der Erfindung sowohl als (herkömmliche) Platine als auch zum Aufbau der integrierten Elektronik (deshalb "intelligente Platine"). "Integriert" heißt natürlich auch, dass es beispielsweise auf die Oberfläche aufgebracht, z.B. gedruckt ist).

Für ein elektronisches Gerät wie ein Sensorlabel, ein Spiel, eine Checkkarte oder ein RFID Tag ist es wichtig, dass mehrere elektronisch verschiedene Bauteile oder Komponenten auf einer größeren Fläche elektrisch verbunden werden. Nachdem die (Herstellungs-)Kosten eine entscheidende Rolle in der organischen Elektronik spielen ist es wichtig, eine Möglichkeit der preisgünstigen Elektronik zu schaffen, mit deren Hilfe ganze Elektronikgeräte in einem Substrat integriert und damit in einem Prozess hergestellt werden können.

Vorteilhafterweise erfolgt die Herstellung des gesamten elektronischen Geräts in einem sogenannten Dünnfilmprozess, (organische dünne Funktionsschichten, die preiswert und einfach herzustellen sind) und/oder in einem Druckprozess, insbesondere bevorzugt zumindest teilweise im roll-to-roll Prozess. Dadurch sind niedrige Kosten und hohe Stückzahlen realisierbar.

Auf einem Substrat oder in einer intelligenten Platine nach der Erfindung kann die (gesamte) Energieversorgung für das elektronische Gerät, wie ein Energiewandler, eine photovoltaische Zelle, ein piezokeramisches Element, eine Spule zur induktiven Kopplung, eine Antenne zur kapazitiven Kopplung, einen Kontakt zu einer externen Stromversorgung, eine Batterie oder ähnliches integriert sein.
Ebenso kann ein Eingabeelement, also ein Sensor, oder eine Tastatur, sowie ein Ausgabeelement, eine Antenne oder sonstiges in dem Substrat oder auf der intelligenten Platine integriert sein. Folgende Bauteile werden hier beispielsweise als Eingabeelement bezeichnet: Sensor (für Druck, elektrischen Strom, elektrische Spannung, Geräusche, Temperatur, Feuchtigkeit, pH-Wert, chemische Verbindungen, Gase, Atem- und/oder Blutalkohol, Analyse von Körperflüssigkeiten oder von wässrigen Ausgangsmaterialien allgemein), Tastatur (einzelne Drucktasten (einfache Verbindungen oder kapazitiv gekoppelte Taster oder induktive Taster), keyboard - Tastatur, Eingabematrix (z.B. Touchscreen)), Mikrophon (Töne, Geräusche), Lichtsensor (auch als Detektor oder Solarzelle).

Folgende Bauteile werden beispielsweise als Ausgabeelemente bezeichnet: Optische Elemente (Leuchtdioden (organisch oder anorganisch), Glühlampen, elektrochrome Elemente (solche, die ihre Farbe oder Lichtabsorption unter Einwirkung von elektrischem Strom/elektrischer Spannung ändern, Flüssigkristall-Anzeigen (LCD); Lautsprecher (konventionelle oder auf piezoaktiven Materialien (organisch oder anorganisch) basierend), Antennen (induktiv als Spule oder kapazitiv), elektrische Kontakte für externe Kontaktierung, Bildschirm (basierend auf allen möglichen Prinzipien wie konventionelle Röhrenbildschirme, LCD (Flüssigkristall) - Anzeigen, Bildschirmen basierend auf elektrochromen Materialien, auf sog. E-ink (Name einer amerikanischen Firma).

Herkömmliche Draht- oder Kabelverbindungen können einfach durch, beispielsweise drucktechnisch herstellbare, strukturierte elektrisch leitende Schichten und/oder Leiterbahnen ersetzt werden.

Nach einer Ausführungsform ist vorgesehen, dass das Substrat auf dem die aktiven Elemente, z.B. einzelne Transistoren oder integrierte Schaltungen aufgebaut sind, gleichzeitig als Platine dient und die hierzu nötigen leitfähigen Verbindungen (oder Widerstände, Spulen oder Antennen) direkt auf dasselbe Substrat mit aufgebracht sind. Beispielsweise können die Source/Drain - oder Gate-Elektroden-Ebenen der integrierten Schaltungen großflächig für diese Leiterbahnen benutzt werden. Damit ist es auch möglich, hybride Aufbauten mit zu umfassen, beispielsweise eine Batterie, einen Taster oder Sensor und/oder einen Silizium-Chip an Stellen auf der intelligenten Platine oder dem Substrat an zu bringen. Leiterbahnen oder leitende Kontakte können beispielsweise auch durch leitfähigen Kleber realisiert sein.

Das Substrat kann eine flexible Folie sein, es kann aber auch aus jedem anderen geeigneten Material, nahezu aus beliebigem Material sein.

Des weiteren ist es möglich, ein preiswertes Display, das auf dem elektrochromen Effekt aufbaut, auf einer intelligenten Platine oder einem Substrat nach der Erfindung zu integrieren, wobei als Displayelement beispielsweise ein elektrochromes Material eingesetzt wird und als Ansteuerschaltung organische Transistoren verwendet werden. Dies ist insbesondere wirtschaftlich interessant, weil bislang Displays fast ausschließlich für hochpreisige Produkte eingesetzt werden.

Das Display kann sowohl steckbar als auch anderweitig integriert werden, es kann aber auch als eigenständiges Bauteil betrachtet werden. Die Verbindungen können beispielsweise durch einen leitfähigen Kleber realisiert werden. Es ist auch eine kontaktlose Übertragung der Daten von einem externen Gerät auf das Display möglich (z.B. durch eine Spule).

Auf dem Substrat können auch weitere Funktionen wie z.B. die Sensoreigenschaften Temperatur, Feuchtigkeit oder weitere logische Funktionen, vorzugsweise die Bauteile auf organischer Basis, aber nicht zwingend. Ebenso kann ein flüchtiger oder nichtflüchtiger Speicher integriert sein (organisch oder anorganisch basiert).

Bei dem elektrochromen Effekt wird die Farbe eines Materials durch Anlegen einer elektrischen Spannung reversibel oder irreversibel verändert. Beispielsweise kann man bei dem Material PEDOT /PSS die Farbe von fast klar zu dunkelblau verändern und bei PANI von grün nach blau. Dies wird durch einen Aufbau realisiert, bei dem neben oder über dem elektrochromen Material eine zweite Elektrode plaziert wird und diese beiden Elemente durch einen Elektrolyten verbunden werden. Durch Anlegen einer Spannung zwischen den beiden Elementen findet eine Redox-Reaktion im elektrochromen Material statt, die schließlich zur Verfärbung führt. In der Regel findet bei dieser Reaktion auch eine deutliche Änderung des elektrischen Widerstandes der Materialien statt.

Für solch ein Display wird eine Ansteuerung benötigt, wenn es sich nicht nur um ein einfaches Symbol handelt, sondern wie beispielsweise bei einem 7 Segment - display oder einem Matrix-Display um eine veränderbare Anzeige handelt. Diese Ansteuerung muss die eingehenden Signale z.B. durch eine NOR Logik so verknüpft zum Display leiten, dass die gewünschte Anzeige erscheint. Diese Ansteuerung ist vorteilhafterweise als organische Schaltung basierend auf organischen Feldeffekt Transistoren aufgebaut, deren Funktion und Aufbau bekannt sind.

Das Display und die Ansteuerelektronik können beispielsweise im selben Produktionsschritt auf dasselbe Substrat integriert werden. Das Substrat ist typischerweise eine preiswerte Polymerfolie (z.B. PET, oder PP, oder PEN.. oder Polyimid). Das Displayprinzip kann sehr einfach und preiswert realisiert werden (z.B. nach der Veröffentlichung vom schwedischen Institut ACREO Auch dieser Aufbau kann im Dünnfilmprozess erfolgen und durch Druckprozesse realisiert werden. Hierdurch sind erstmals bei Displays auch niedrige Kosten und hohe Stückzahlen zu erzielen.

Im folgenden wird die Erfindung noch anhand praktischer Beispiele, die Ausführungsformen zeigen, näher erläutert:
- Figur 1: zeigt die Draufsicht auf ein elektronisches Gerät, das zumindest ein organisches Bauteil umfasst
- Figur 2: zeigt die Draufsicht auf das gleiche elektronische organische Gerät, allerdings zeigt sie die unter dem Gehäuse befindliche Schicht.
- Figur 3: zeigt die Draufsicht auf ein 7 Segment IPC-Display und
- Figur 4: zeigt den Querschnitt durch ein IPC-Display.

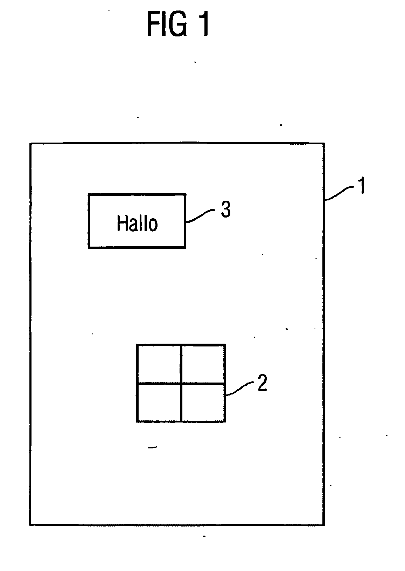

Figur 1 zeigt die Fläche der intelligenten Platine oder die Substratfläche 1, wobei das Substrat beispielsweise eine flexible Folie, ein Karton, ein biegsames oder ein herkömmliches Glassubstrat oder ähnliches sein kann. Außen sichtbar sind die Eingabeelemente (Tastatur, Sensoren etc.) und die Ausgabeelemente 3 (Display, Anzeige, Leuchtelement, Lautsprecher). Durch eine undurchsichtige Deckfläche ist das Innenleben des elektronischen Gerätes verdeckt. Die Deckfläche kann beliebig gestaltet oder bedruckt sein. Jedes der genannten oder einsetzbaren elektronischen Bauteile kann organische sein, wobei auch organische und herkömmliche, auf Siliziumbasis beruhende beliebig kombiniert sein können.

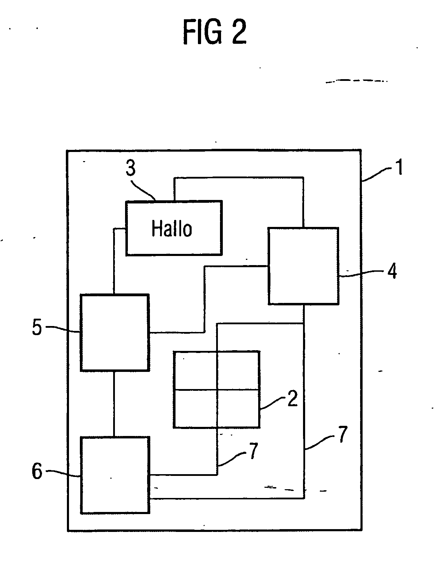

Figur 2 zeigt den Aufbau der intelligenten Platine oder des erfindungsgemäßen Substrats, wobei die Schicht unterhalb der undurchsichtigen Deckfläche ("das Innenleben") aus Figur 1 gezeigt wird. Hier erkennt man, dass auf dem Substrat 1, neben den sichtbaren Ein- und Ausgabeelementen 2,3 auch weitere Elemente 4,5,6 und dazwischen elektrischen Verbindungen 7 vorhanden sind. Diese Elemente 4 bis 7 können entweder auf dem Substrat 1 direkt aufgebrachte elektronische Elemente (integrierte Schaltung, Sensorik, Speicher) sein aber auch als Hybride aufgebrachte Elemente wie Batterien, Lautsprecher, konventionelle Elektronik, Speicher usw. sein. Nach der Erfindung können auf dem Substrat sowohl die leitenden Verbindungen als auch die aktiven Elektronikelemente aufgebracht sein. Damit kann die Erfindung beispielsweise auch zur preiswerten Herstellung von Grußkarten mit kleinen elektronischen Spielen eingesetzt werden. Bei herkömmlichen Grußkarten, bei denen beim Öffnen eine kleine Melodie abgespielt wird oder ähnliches, sind bisher die einzelnen Bauteile beispielsweise durch Drähte verbunden. Diese Verbindungen können nach der Erfindung wesentlich einfacher gestaltet werden.

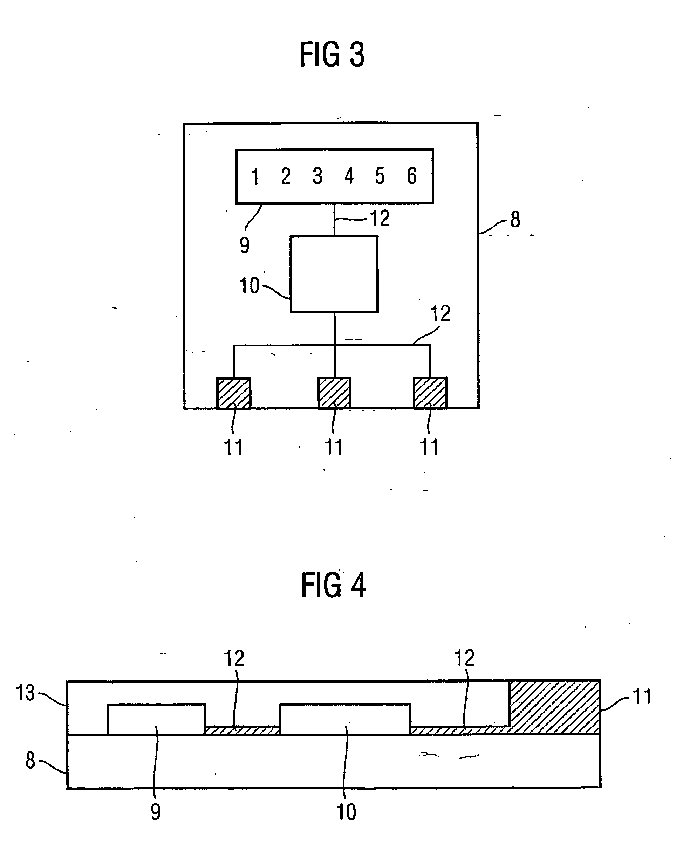

Figur 3 zeigt die Draufsicht auf ein 7 Segment IPC-Display. Auf einem flexiblen Substrat 8 ist ein electrochromes Display 9 sowie hierfür notwendige Ansteuerelektronik 10 basierend auf organischen Transistoren aufgebracht. Zur Kontaktierung des Displays sind Kontakte 11 vorgesehen, die über elektrische Verbindungen 12 die elektrische Verbindung zwischen der Ansteuerelektronik 10 und dem Display 9 realisieren.

Figur 4 schließlich zeigt noch einen Querschnitt durch das IPC Display. Neben den bereits in Figur 3 beschriebenen Elementen ist noch die Schutzschicht 13 zu erkennen, die das System vor äußeren Einflüssen schützt.

Bei dem elektrochromen Display werden beispielsweise funktionale Polymere wie PANI, PEDOT, oder ähnliche Materialien, beispielsweise Makromoleküle, die durch chemische Zusätze dotiert wurden, eingesetzt.

Durch die Erfindung ist es erstmals möglich, eine Platine als aktives elektronisches Bauelement in ein elektronisches Gerät mitzuintegrieren und sie nicht nur sozusagen als Grundplatte zu nutzen. Dadurch wird ein elektronisches Gerät geschaffen, das nicht nur wesentlich flacher und kompakter aufgebaut ist, sondern ein elektronisches Gerät, das inklusive Platine und sogar, je nach Ausführungsform, inklusive Display einfach, preiswert, also low-cost Einwegprodukt hergestellt werden kann.

## Patentansprüche

1. Platine (1, 8) eines elektronischen Gerätes, wobei die Platine (1, 8) zumindest ein in die Platine (1, 8) integriertes aktives organisches elektronisches Bauteil umfasst, **dadurch gekennzeichnet, dass** zumindest eine Elektrodenschicht des integrierten aktiven organischen elektronischen Bauteils auch die Leiterbahnschicht zur Kontaktierung und Befestigung eines konventionellen siliziumbasierten Halbleiterbauelements auf der Platine ist

2. Platine (1, 8) für ein elektronisches Gerät nach Anspruch 1,
**dadurch gekennzeichnet, dass**
in die Platine (1, 8) zumindest ein aktives organisches Bauteil neben zumindest einem passiven organischen Bauteil integriert ist.

3. Platine (1, 8) nach Anspruch 2, wobei das aktive Bauelement ein organischer Transistor, eine organische Diode, eine organische Photozelle, eine organische integrierte Schaltung und/oder das passive organische Bauteil eine elektrisch leitende Verbindung, ein Widerstand, eine Spule und/oder ein Kondensator ist.

4. Platine (1, 8) nach einem der vorstehenden Ansprüche,
**dadurch gekennzeichnet, dass**
in die Platine (1, 8) eine Energieversorgung, also beispielsweise ein Energiewandler, eine photovoltaische Zelle, ein piezokeramisches Element, eine Spule zur induktiven Kopplung, eine Batterie oder Ähnliches integriert ist.

5. Platine (1, 8) nach einem der vorstehenden Ansprüche,
**dadurch gekennzeichnet, dass**
in die Platine (1, 8) ein Eingabeelement (2) und/oder ein Ausgabeelement (3) integriert ist.

6. Platine (1, 8) nach einem der vorstehenden Ansprüche,
**dadurch gekennzeichnet, dass**
Leitungen, wie Drahtleitungen oder leitende Kontakte durch strukturierte leitfähige Schichten, Elektroden wie die Source und Drain Elektroden und/oder leitfähigen Kleber realisiert sind.

7. Platine (1, 8) nach einem der vorstehenden Ansprüche
**dadurch gekennzeichnet, dass**
in die Platine (1, 8) ein Anzeigeelement und/oder ein Display (9) integriert ist.

8. Platine (1, 8) nach Anspruch 7,
**dadurch gekennzeichnet, dass**
das Display (9) elektrochromes Material, flüssigkristalline Elemente und/oder organische Leuchtdioden umfasst.

9. Platine (1, 8) nach Anspruch 7 oder 8,
**dadurch gekennzeichnet, dass**
in die Platine (1, 8) eine zu dem Display (9) gehörige Ansteuerelektronik (10) integriert ist.

10. Platine (1, 8) nach Anspruch 9,
**dadurch gekennzeichnet, dass**
die Ansteuerelektronik(10) zumindest einen organischen Feldeffekt-Transistor umfasst.

11. Verwendung einer Platine nach einem der Ansprüche 1 bis 10 für ein elektronisches Gerät wie ein Sensorlabel, ein Werbeetikett, ein Preisschild, ein Spiel, eine Checkkarte und/oder einen RFID Tag.

## Claims

1. Circuit board (1, 8) of an electronic device, the circuit board (1, 8) comprising at least one active organic electronic component integrated in the circuit board (1, 8), **characterized in that** at least one electrode layer of the integrated active organic electronic component is also the conductive track layer for making contact with and securing a conventional silicon-based semiconductor component on the circuit board.

2. Circuit board (1, 8) for an electronic device according to Claim 1, **characterized in that** at least one active organic component in addition to at least one passive organic component is integrated in the circuit board (1, 8).

3. Circuit board (1, 8) according to Claim 2, wherein the active component is an organic transistor, an organic diode, an organic photocell, an organic integrated circuit and/or the passive organic component is an electrically conducting connection, a resistor, a coil and/or a capacitor.

4. Circuit board (1, 8) according to one of the preceding claims, **characterized in that** a power supply, i.e. for example an energy transducer, a photovoltaic cell, a piezoceramic element, a coil for inductive coupling, a battery or the like is integrated in the circuit board (1, 8).

5. Circuit board (1, 8) according to one of the preceding claims, **characterized in that** an input element (2) and/or an output element (3) is integrated in the circuit board (1, 8).

6. Circuit board (1, 8) according to one of the preceding claims, **characterized in that** lines such as wire lines or conducting contacts are produced using structured conductive layers, electrodes such as source and drain electrodes and/or conductive adhesives.

7. Circuit board (1, 8) according to one of the preceding claims, **characterized in that** a visualization element and/or a display (9) is integrated in the circuit board (1, 8).

8. Circuit board (1, 8) according to Claim 7, **characterized in that** the display (9) comprises electrochromic material, liquid crystalline elements and/or organic light-emitting diodes.

9. Circuit board (1, 8) according to Claim 7 or 8, **characterized in that** driver electronics (10) associated with the display (9) are integrated in the circuit board (1, 8).

10. Circuit board (1, 8) according to Claim 9, **characterized in that** the driver electronics (10) comprise at least one organic field-effect transistor.

11. Use of a circuit board according to one of Claims 1 to 10 for an electronic device such as a sensor label, an advertising ticket, a price marker, a game, a check card and/or an RFID tag.

## Revendications

1. Platine (1, 8) d'un appareil électronique, laquelle platine (1, 8) comporte au moins un composant électronique organique actif intégré dans la platine (1, 8), **caractérisée en ce qu'**au moins une couche d'électrode du composant électronique organique actif intégré est également la couche de pistes conductrices pour contacter et fixer un composant semi-conducteur conventionnel à base de silicium sur la platine.

2. Platine (1, 8) pour un appareil électronique selon la revendication 1,
**caractérisée en ce**
**qu'**au moins un composant organique actif est intégré sur la platine (1, 8) à côté d'au moins un composant organique passif.

3. Platine (1, 8) selon la revendication 2, le composant actif étant un transistor organique, une diode organique, une photocellule organique, un circuit intégré organique et/ou le composant organique passif étant une liaison électroconductrice, une résistance, une bobine et/ou un condensateur.

4. Platine (1, 8) selon l'une quelconque des revendications précédentes,
**caractérisée en ce**
**qu'**une alimentation électrique, soit par exemple un convertisseur d'énergie, une cellule photovoltaïque, un élément piézocéramique, une bobine pour le couplage inductif, une batterie ou un dispositif similaire, est intégrée sur la platine (1, 8).

5. Platine (1, 8) selon l'une quelconque des revendications précédentes,
**caractérisée en ce**
**qu'**un élément d'entrée (2) et/ou un élément de sortie (3) est intégré sur la platine (1,8).

6. Platine (1, 8) selon l'une quelconque des revendications précédentes,
**caractérisée en ce**
**que** des lignes, telles que de lignes filaires ou des contacts conducteurs, sont réalisées par des couches conductrices structurées, des électrodes telles que les électrodes de source et de drain et/ou des colles conductrices.

7. Platine (1, 8) selon l'une quelconque des revendications précédentes,
**caractérisée en ce**
**qu'**un élément d'affichage et/ou un écran (9) est intégré sur la platine (1, 8).

8. Platine (1, 8) selon la revendication 7,
**caractérisée en ce**
**que** l'écran (9) comprend un matériau électrochrome, des éléments à cristaux liquides et/ou des diodes électroluminescentes organiques.

9. Platine (1, 8) selon la revendication 7 ou 8,
**caractérisée en ce**
**qu'**un circuit électronique de commande associé à l'écran (9) est intégré sur la platine (1, 8).

10. Platine (1, 8) selon la revendication 9,
**caractérisée en ce**
**que** le circuit électronique de commande (10) comporte au moins un transistor à effet de champ organique.

11. Utilisation d'une platine selon l'une des revendications 1 à 10 pour un appareil électronique tel qu'une étiquette de capteur, une étiquette publicitaire, une étiquette de prix, un jeu, une carte-chèque et/ou une étiquette RFID.
